# EUROPÄISCHE PATENTSCHRIFT

(11) **EP 3 456 160 B1**
(45) Veröffentlichungstag und Bekanntmachung des Hinweises auf die Patenterteilung: **03.07.2019**
(21) Anmeldenummer: 17728449.4
(22) Anmeldetag: 10.05.2017
(51) Int. Cl.: H05K 1/11, H05K 3/20, G06K 19/077, H01L 23/498, H05K 3/00, H05K 3/32

(54) **LEITERBAHNSTRUKTUR, INSBESONDERE FÜR EINEN LEAD-FRAME FÜR EINE SMARTCARD-ANWENDUNG, MIT MINDESTENS ZWEI ÜBEREINANDER LIEGENDEN LEITERBAHN-EBENEN**
CIRCUIT PATTERN STRUCTURE, IN PARTICULAR FOR A LEADFRAME FOR A SMART CARD APPLICATION, WITH AT LEAST TWO SUPERPOSED PLANES OF CONDUCTIVE PATTERNS
STRUCTURE DE TRACÉS CONDUCTEURS, EN PARTICULIER POUR UNE GRILLE DE CONNEXION DESTINÉE À ÊTRE UTILISÉE POUR UNE CARTE À PUCE INTELLIGENTE, COMPRENANT AU MOINS DEUX PLANS DE TRACÉS CONDUCTEURS SUPERPOSÉS

(30) Priorität: 11.05.2016 DE 102016005657; 11.05.2016 DE 202016002993 U
(43) Veröffentlichungstag der Anmeldung: 20.03.2019
(73) Patentinhaber: Linxens Holding, 78200 Mantes la Jolie (FR)
(72) Erfinder: MORGENTHALER, Frédéric, 75223 Niefern (DE); KALCK, Sébastien, 75223 Niefern (DE)
(74) Vertreter: Leitner, Waldemar
(86) Internationale Anmeldenummer: PCT/EP2017/025118
(87) Internationale Veröffentlichungsnummer: WO 2017/194200

(56) Entgegenhaltungen:
- EP-A1- 0 891 603
- EP-A1- 0 992 065

## Beschreibung

Die Erfindung betrifft eine Leiterbahnstruktur, insbesondere für einen Lead-Frame für eine Smartcard-Anwendung, die mindestens eine erste Leiterbahn-Ebene mit mehreren ersten Leiterbahnen und mindestens eine zweite Leiterbahn-Ebene mit mehreren zweiten Leiterbahnen besitzt, wobei übereinander liegende Leiterbahn-Ebenen von einem Isolator getrennt sind, wobei mindestens eine erste Leiterbahn der ersten Leiterbahn-Ebene mindestens eine sie durchsetzende Bondöffnung und der Isolator eine unter dieser mindestens einen Bondöffnung liegende Durchtrittsöffnung aufweist, durch welche ein Bonddraht hindurchführbar und in elektrisch leitenden Kontakt mit einer ersten Leiterbahn der zweiten Leiterbahn-Ebene bringbar ist, und wobei mindestens die vorgenannte erste Leiterbahn der ersten Leiterbahn-Ebene und die zu ihr benachbarte Leiterbahn der ersten Leiterbahn-Ebene durch einen Schlitz und mindestens die vorgenannte erste Leiterbahn der zweiten Leiterbahn-Ebene und die zu ihr benachbart liegende Leiterbahn der zweiten Leiterbahn-Ebene durch einen weiteren Schlitz voneinander getrennt sind.

Eine derartige Leiterbahnstruktur ist bekannt und wird allgemein zur Herstellung von elektronischen Vorrichtungen, insbesondere für Smartcard-Anwendungen. verwendet. Hierzu wird in oder auf die erste Leiterbahn-Ebene ein elektronisches Bauteil, insbesondere ein Chip für eine Smartcard, ein- oder aufgesetzt. Die Kontaktierung dieses elektronischen Bauteils mit den Leiterbahnen der ersten und/oder der zweiten Leiterbahn-Ebene erfolgt in ebenfalls an und für sich bekannter und daher nicht näher beschriebenen Art und Weise über Bonddrähte, die vom elektronischen Bauteil ausgehen. Um einen Bonddraht des elektrischen Bauteils mit einer Kontaktfläche einer Leiterbahn der zweiten Leiterbahn-Ebene elektrisch leitend zu verbinden, werden sogenannte Vias eingesetzt, also Bondöffnungen, welche die erste Leiterbahn-Ebene und den zwischen der ersten Leiterbahn-Ebene und der zweiten Leiterbahn-Ebene angeordneten Isolator durchsetzt. Insbesondere bei sogenannten "dual-interface-Anwendungen" ist es für eine Vielzahl von Fällen erforderlich, den Bonddraht durch eine Bondöffnung einer Leiterbahn der ersten Leiterbahn-Ebene hindurchzuführen, um mit dem Bonddraht die unter der Bondöffnung liegende Leiterbahn der zweiten Leiterbahn-Ebene elektrisch zu kontaktieren. Hierbei tritt das Problem auf, dass beim Bonden oder später der Bonddraht den Rand der Bondöffnung berührt, wodurch ein elektrischer Kontakt zwischen dem Bonddraht und der die Bondöffnung aufweisenden Leiterbahn der ersten Leiterbahn-Ebene hergestellt wird. Die kann zu einem Kurzschluss oder zu anderen unerwünschten Funktionsbeeinträchtigungen führen. Zur Vermeidung dieses Problems ist bei bekannten Leiterbahnstrukturen vorgesehen, dass zumindest die Bondöffnungen aufweisenden Leiterbahnen der ersten Leiterbahn-Ebene und die korrespondierenden Leiterbahnen der zweiten Leiterbahn-Ebene jeweils durch mechanische Schlitze separiert sind, sodass nebeneinander liegende Leiterbahnen der ersten Leiterbahn-Ebene bzw. der zweiten Leiterbahn-Ebene durch die zwischen ihnen angeordneten Schlitze elektrisch voneinander isoliert sind. Nachteilig bei derartigen bekannten Leiterbahnstrukturen ist, dass die benachbarte Leiterbahnen der ersten Leiterbahn-Ebene trennenden Schlitze jeweils über den zwei benachbarten Leiterbahnen der zweiten Leiterbahn-Ebene trennenden Schlitzen liegen. Dies beeinträchtigt in nachteiliger Art und Weise die mechanische Steifigkeit einer derartigen Leiterbahnstruktur, da der Zusammenhalt zwischen der ersten Leiterbahn-Ebene und der zweiten Leiterbahn-Ebene im Bereich dieser Schlitze im Wesentlichen nur durch den zwischen diesen beiden Leiterbahn-Ebenen angeordneten Isolator, üblicherweise eine Folie aus isolierendem Material, welche eine Dicke von einigen wenigen Mikrometer besitzt, ausgebildet wird.

Aus der EP 0 891 603 A1/WO 98/28709 ist ein nicht-leitendes, ein Band oder einen Nutzen bildendes Substrat bekannt, auf dem eine Vielzahl von Trägerelementen, insbesondere zum Einbau in eine Chipkarte, ausgebildet ist, indem die eine Seite des Substrats mit leitenden Kontaktflächen und die andere Seite mit Leiterstrukturen versehen ist. Es sind Ausnehmungen im Substrat vorgesehen, durch die hindurch zu Testzwecken ein Zugriff auf Spulenanschlüsse des Halbleiterchips von der Kontaktflächenseite möglich ist, solange das Trägerelement noch im Band oder im Nutzen ist. Die Ausnehmungen sind als mit den Leiterstrukturen verbundene Durchkontaktierungen ausgebildet. Auf der der Kontaktfläche gegenüberliegenden Seite sind die Ausnehmungen durch jeweils eine leitende, mit den Leiterstrukturen verbundene Fläche abgedeckt. Es werden somit zwei benachbarte Leiterbahnen der eine erste Leiterbahn-Ebene ausbildenden Kontaktseite des Substrats trennende Schlitze und weitere Schlitze auf der zweiten Seite des Substrats ausgebildet.

Aus der EP 0 992 065 A1/WO 99/53545 ist eine Folie als Träger von integrierten Schaltungen bekannt, die in Form eines langgestreckten Filmstreifens mit Randlochungen und Leiterbahnen als Träger eine Vielzahl von integrierten Schaltungen zum Einbau, vorzugsweise in Chip-Karten, ausgebildet ist, wobei die Leiterbahnen aus einer Metallfolie gestanzt und nur auf eine mit Lochungen bzw. Durchbrüchen versehene Kunststoffolie aufgeklebt sind. Auf beiden Seiten der Kunststoffolie ist jeweils eine Metallfolie mit unterschiedlichen Leiterbahn-Mustern aufgeklebt, wobei die Metallfolien auf beiden Seiten zusätzlich zu den vorgegebenen Leiterbahn-Muster Unterbrechungen aufweisen, um in Längsrichtung des Folienstreifens in kurzen Abständen des Gesamtquerschnitts beider Metallfolien senkrecht zur Längsrichtung des Filmstreifens wesentlich zu verringern.

Es ist Aufgabe der vorliegenden Erfindung, eine Leiterbahnstruktur der eingangs genannten Art derart weiterzubilden, dass eine verbesserte mechanische Stabilität ausgebildet wird.

Diese Aufgabe wird daher erfindungsgemäß dadurch gelöst, dass dieser mindestens eine Schlitz der ersten Leiterbahn-Ebene in Bezug auf den vorgenannten mindestens einen weiteren Schlitz der zweiten Leiterbahn-Ebene versetzt angeordnet ist.

Durch die erfindungsgemäß vorgesehene versetzte Anordnung der benachbarte Leiterbahnen der ersten Leiterbahn-Ebene trennenden Schlitze und der benachbarte Leiterbahnen der zweiten Leiterbahn-Ebene trennenden weiteren Schlitze wird in vorteilhafter Art und Weise eine verbesserte mechanische Stabilität der Leiterbahnstruktur erreicht, da mindestens ein zwei benachbarte Leiterbahnen der ersten Leiterbahn-Ebene trennender Schlitz gegenüber dem zugehörigen weiteren Schlitz, der in der unter der ersten Leiterbahn-Ebene angeordneten zweiten Leiterbahn-Ebene vorgesehen ist, nun nicht mehr-wie bei den bekannten Leiterbahnstrukturen - über dem entsprechenden Schlitz der ersten Leiterbahn-Ebene liegt, sondern gegenüber diesem versetzt. Vorzugsweise sind eine Vielzahl oder weiter bevorzugt alle Schlitze der ersten Leiterbahn-Ebene gegenüber den entsprechenden weiteren Schlitzen der zweiten Leiterbahn-Ebene derart versetzt angeordnet. Hierdurch wird in vorteilhafter Art und Weise erreicht, dass im Bereich zusammenwirkender oder zusammengehöriger Schlitze der beiden Leiterbahn-Ebenen der Zusammenhalt zwischen diesen beiden Leiterbahn-Ebenen nicht nur die zwischen diesen beiden Leiterbahn-Ebenen vorgesehene Isolator-Folie bewirkt wird.

Vorzugsweise ist gemäß einer vorteilhaften Weiterbildung einer Erfindung vorgesehen, dass mindestens ein Schlitz der ersten Leiterbahn-Ebene durch die zugehörige Bondöffnung hindurchgeht. Hierdurch wird in vorteilhafter Art und Weise eine besonders günstige Führung und auch Herstellbarkeit der erfindungsgemäß versetzt angeordneten Schlitze erreicht.

Eine weitere vorteilhafte Weiterbildung der Erfindung sieht vor, dass zumindest in einem Teil des Randbereichs der ersten Leiterbahn-Ebene im Wesentlichen kein elektrisch leitendes Material vorhanden ist. Bevorzugt wird hierbei, dass der oder diese Randbereiche der ersten Leiterbahn-Ebene und/oder der zweiten Leiterbahn-Ebene zumindest in denjenigen Teilen, in denen die Gefahr einer unerwünschten Kontaktierung zwischen der ersten Leiterbahn-Ebene und der zweiten Leiterbahn-Ebene besteht, im Wesentlichen frei von elektrisch leitendem Material ist. Durch diese Maßnahmen wird erreicht, dass die Gefahr, dass bei einem Trennvorgang zur Vereinzelung der erfindungsgemäßen Leiterbahn-Strukturen in Folge einer mechanischen Beaufschlagung des oder der Randbereiche einer der Leiterbahn-Ebenen, z. B. der ersten Leiterbahn-Ebene, mit einem Trennwerkzeug elektrisch leitendes Material dieses Randbereichs zu der Oberfläche der unter dieser Leiterbahn-Ebene liegenden weiteren Leiterbahn-Ebene oder - bei einem drei oder mehrlagigen Aufbau - zu den unter der erstgenannten Leiterbahn-Ebene liegenden weiteren Leiterbahn-Ebenen gedrückt wird, eliminiert oder zumindest verringert wird. Der Gefahr von Funktionsbeeinträchtigungen und/oder Funktionsstörungen durch eine derart unerwünscht hergestellte elektrisch leitende Verbindung zwischen zwei oder mehr Leiterbahn-Ebenen wird somit in besonders einfacher Art und Weise entgegengewirkt. Eine derartige Maßnahme besitzt insbesondere für den Verwender derartiger Leiterbahn-Strukturen, also insbesondere den Hersteller von Smartcards, den Vorteil, dass der Herstellungsvorgang einer derartigen Smartcard in vorteilhafter Art und Weise vereinfacht wird, da der Smartcard-Hersteller beim Verarbeiten der erfindungsgemäßen Leiterbahn-Strukturen den zu deren Vereinzelung erforderlichen Trennvorgang durchführen kann, ohne besonders exakt darauf achten zu müssen, dass beim Heraustrennen der einzelnen Leiterbahn-Strukturen aus dem sie aufnehmenden Träger bei dem hierzu erforderlichen Trennvorgang, z. B. einem Stanzen oder Schneiden, keine unerwünschte Kontaktierung zwischen zwei oder mehreren Leiterbahn-Ebenen durch beim Trennvorgang entstehende Stanz- und/oder Schneidrückstande erfolgt.

Eine weitere vorteilhafte Weiterbildung der Erfindung sieht vor, dass der die beiden Leiterbahn-Ebenen trennende Isolator als eine elektrisch isolierende Folie ausgebildet ist, und dass diese Folie vorzugsweise an beiden Seiten mit einer Klebeschicht versehen ist. Eine derartige Maßnahme besitzt den Vorteil, dass hierdurch in einfacher Art und Weise die beiden Leiterbahn-Ebenen zu der erfindungsgemäßen Leiterbahnstruktur verbunden werden können, indem die erste Leiterbahn-Ebene mit der ersten Seite des isolierenden Folie und die unter der ersten Leiterbahn-Ebene angeordnete zweite Leiterbahn-Ebene mit der zweiten Seite dieser doppelseitig klebenden isolierenden Folie verklebt wird.

Weitere vorteilhafte Weiterbildungen der Erfindung sind Gegenstand der Unteransprüche.

Weitere Vorteile der Erfindung sind dem Ausführungsbeispiel zu entnehmen, das im Folgenden anhand der Figuren beschrieben ist. Es zeigen:
- Figur 1: ein Ausführungsbeispiel einer Leiterbahnstruktur mit zwei übereinander liegenden Leiterbahn-Ebenen in einer Draufsicht von ihrer Chipseite her,
- Figur 2: das Ausführungsbeispiel der Figur 1 in einer Draufsicht von der Chip-Seite her,
- Figur 3: das Ausführungsbeispiel der Figur 1 in einer Unteransicht von der Kontaktseite her,
- Figur 4: eine Draufsicht auf eine Ausführungsform eines zwischen den beiden Leiterbahn-Ebenen angeordneten Isolators,
- Figur 5: eine vergrößerte Darstellung eines Schnitts entlang der Linie A-A der Figur 1,
- Figur 6: einen Streifen aus elektrisch leitendem Material mit einer Vielzahl von ersten Leiterbahn-Ebenen, und
- Figur 7: einen Streifen aus elektrisch leitendem Material mit einer Vielzahl von zweiten Leiterbahn-Ebenen

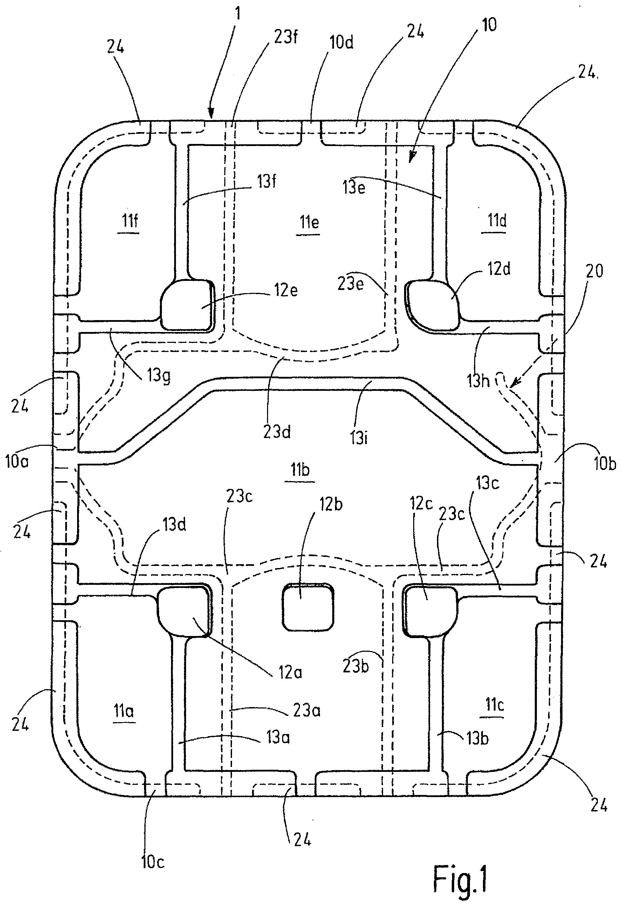

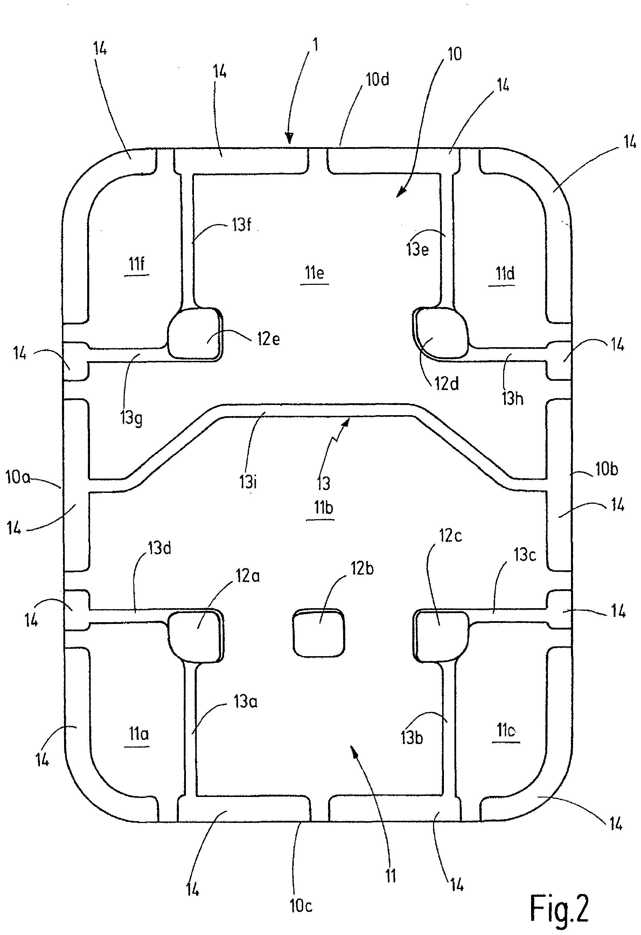

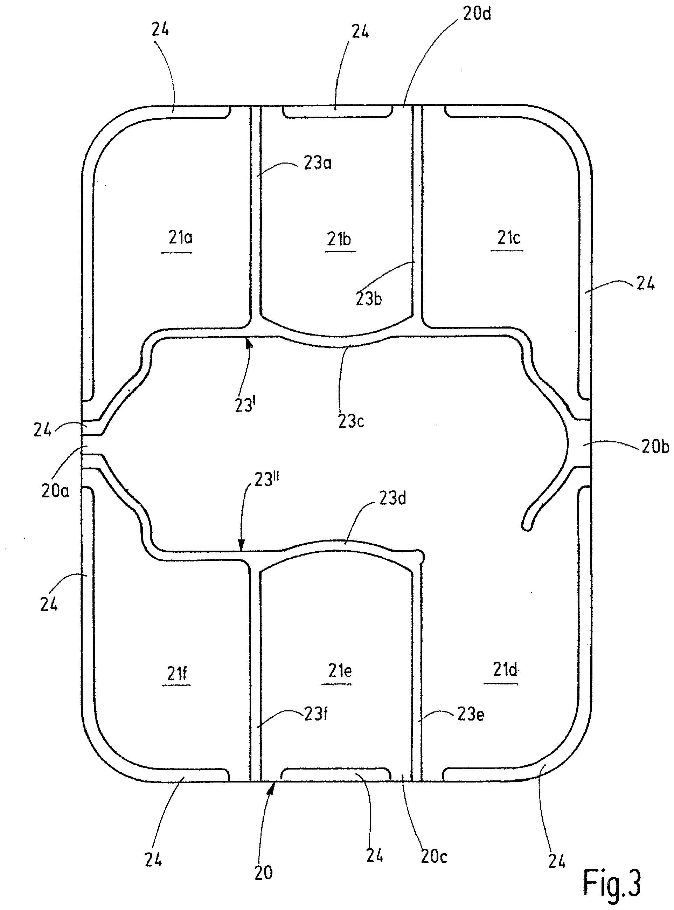

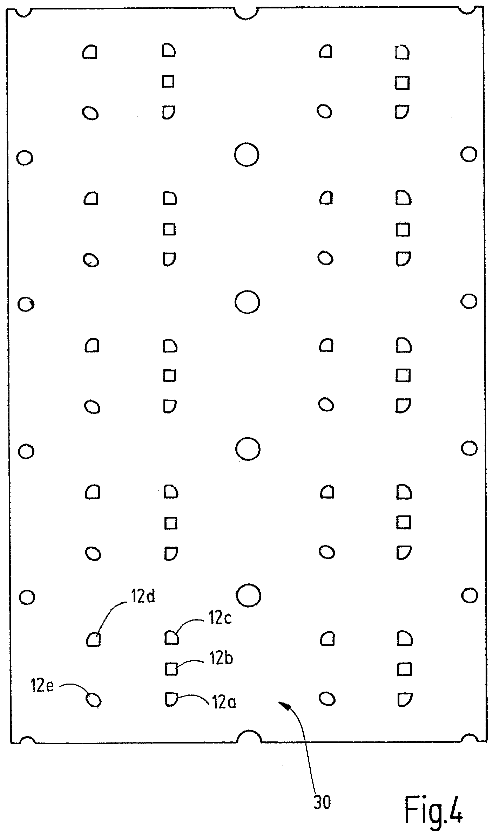

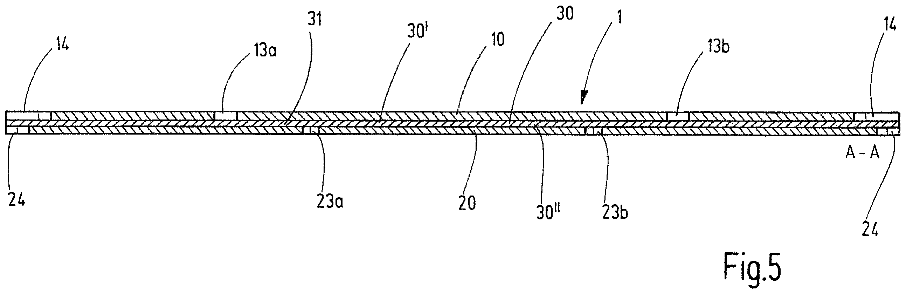

In den Figuren 1 bis 5 ist ein Ausführungsbeispiel einer Leiterbahnstruktur 1 mit zwei übereinanderliegenden Leiterbahn-Ebenen 10, 20 dargestellt, wobei die Figur 1 eine Draufsicht auf die Leiterbahnstruktur 1 von ihrer sogenannten ChipSeite zeigt. Die Leiterbahnstruktur 1 weist im hier gezeigten Fall die erste Leiterbahn-Ebene 10 (siehe Figur 2) und die zweite Leiterbahn-Ebene 20 (siehe Figur 3) auf, welche - wie am besten aus dem Querschnitt der Figur 5 ersichtlich ist - durch einen Isolator 30 (siehe Figur 4) von einander getrennt sind, der im hier gezeigten Fall als eine Folie aus einem isolierenden Material 31 ausgebildet ist. Der besseren Darstellung halber sind in der Figur 1 die Strukturen der zweiten Leiterbahn-Ebene 20 strichliert sowie der Isolator 30 durchsichtig dargestellt, um die räumliche Beziehung der einzelnen Leiterbahnen 11 bzw. 21 der ersten Leiterbahn-Ebene 10 bzw. der zweiten Leiterbahn-Ebene 20 zu zeigen.

Eine Anzahl von Leiterbahnen 11 der ersten Leiterbahn-Ebene 10 weist Bondöffnungenen 12a-12e auf, welche die entsprechenden Leiterbahnen 11 durchsetzen. Der unter der ersten Leiterbahn-Ebene 10 angeordnete Isolator 30 weist - wie am besten aus der Figur 4 ersichtlich ist - eine Anzahl von unterhalb der entsprechenden Bondöffnung 12 der ersten Leiterbahn-Ebene 10 liegenden Durchtrittsöffnungen auf, sodass sogenannte Vias ausgebildet werden, welche es erlauben, ein in oder auf der ersten Leiterbahn-Ebene 10 angeordnetes elektronisches Bauteil (nicht gezeigt), insbesondere einen Chip für eine Smartcard, mittels entsprechender Bonddrähte (nicht gezeigt) mit Kontaktbereichen einer entsprechenden Anzahl von Leiterbahnen 21 der zweiten Leiterbahn-Ebene 20 zu verbinden. Ein derartiger Aufbau einer Leiterbahnstruktur 1 ist bekannt und muss daher nicht mehr näher beschrieben werden. Dem Fachmann ist aus der nachfolgenden Beschreibung ersichtlich, dass der hier gezeigte Grundaufbau der Leiterbahnstruktur 1 nur exemplarischen Charakter besitzt und die Allgemeingültigkeit der folgenden Überlegungen nicht einschränkt. Insbesondere ist es natürlich auch möglich, bei der Leiterbahnstruktur 1 mehr als zwei übereinander liegende Leiterbahn-Ebenen 10, 20 aus einem elektrisch leitfähigen Material vorzusehen, wobei die einzelnen Leiterbahn-Ebenen durch einen Isolator 30 elektrisch getrennt sind.

Die Figur 2 zeigt nun eine Draufsicht auf die erste Leiterbahn-Ebene 10. Man erkennt die Leiterbahnen 11a-11f, die Bondöffnungen 12a-12e sowie Schlitze 13a-13i, welche die entsprechenden Leiterbahnen 11a-11f voneinander trennen und somit elektrisch isolieren. Die Leiterbahn 11a ist durch die Schlitze 13a und 13d von der Leiterbahn 11b getrennt. In entsprechender Art und Weise trennen die Schlitze 13b und 13c die Leiterbahn 11c und die vorgenannte Leiterbahn 11b. Die Leiterbahn 11d und die Leiterbahn 11e sind durch die Schlitze 13e und 13h getrennt, während die Leiterbahnen 11f und 11e durch die Schlitze 13f und 13g getrennt sind. Ein von dem in Figur 2 linken Rand 10a der Leiterbahn-Ebene 10 ausgehender und zu deren rechter Rand 10b durchgehender Schlitz 13i trennt die Leiterbahnen 11b und 11e. Wie aus den Figuren ersichtlich ist, wird bevorzugt, dass die entsprechenden Schlitze 13a-13h nicht, wie bei den bekannten Leiterbahnstrukturen, um die Bondöffnungen herumgeführt werden, sondern durch diese hindurchlaufen. Z. B. mündet der vom unteren Rand 10c der ersten Leiterbahn-Ebene 10 ausgehende Schlitz 13a in die Bondöffnung 12a, der Schlitz 13d geht von der Bondöffnung 12a aus und verläuft zu dem ersten Rand 10a der ersten Leiterbahn-Ebene 10. Die mit der Bondöffnung 12c zusammenwirkender Schlitze 13d und 13c sind entsprechend ausgebildet, genauso wie die mit der Bondöffnung 12d zusammenwirkenden Schlitze 13e und 13h. Der vom oberen Rand 10d der ersten Leiterbahn-Ebene 10 ausgehende Schlitz 13f läuft zur vierten Bondöffnung 12e und der weitere Schlitz 13d geht von dieser aus und läuft zum ersten Rand 10a der ersten Leiterbahn-Ebene 10.

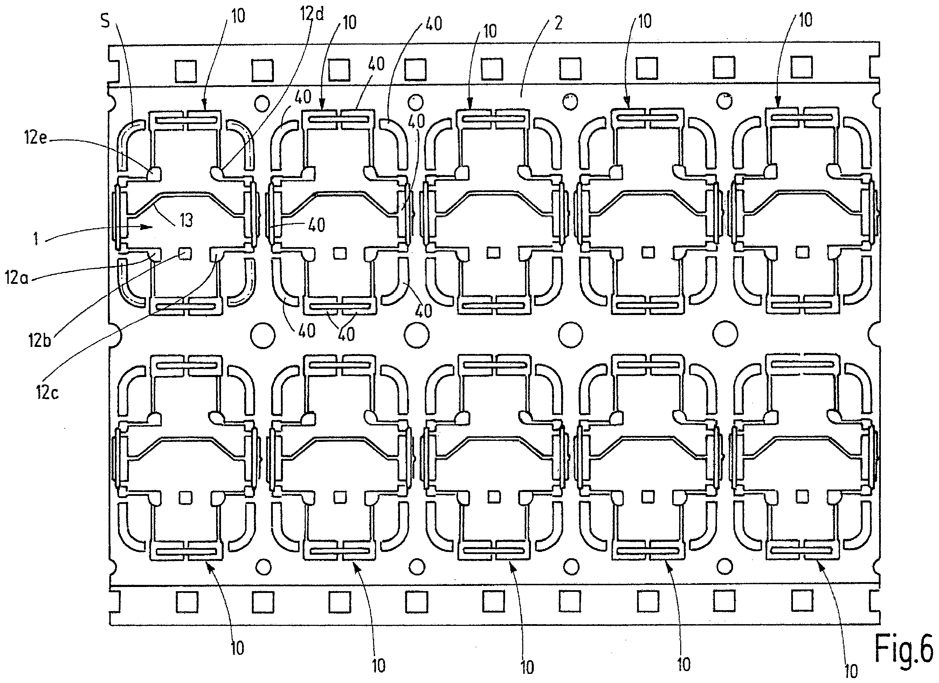

Bevorzugt wird, dass die einzelnen Schlitze 13a, 13d bzw. 13b und 13c bzw. 13e und 13h bzw. 13d und 13f sowie die entsprechenden Bondöffnungen 12a bzw. 12c bzw. 12d bzw. 12e nicht separat, sondern als eine zusammenhängende Struktur ausgebildet sind, sodass diese jeweils - wie nachstehend beschrieben - mittels eines einzigen Arbeitsvorgangs, insbesondere eines Stanzvorgangs, aus dem zur Herstellung der ersten Leiterbahn-Ebene 10 verwendeten Trägermaterial 2 (siehe Figur 6) ausgebildet werden können.

Man erkennt des Weiteren aus der Figur 2, dass die Leiterbahn-Ebene 10 entlang ihrer Ränder 10a-10d Bereiche 14 aufweist, welche frei oder zumindest weitgehend frei von elektrisch leitendem Material sind. Wie weiter unten noch erläutert wird, dient eine derartige Maßnahme dazu, eine unerwünschte elektrische Kontaktierung der ersten Leiterbahn-Ebene 10 und der zweiten Leiterbahn-Ebene 20 zu vermeiden bzw. die Gefahr einer derartigen elektrischen Kontaktierung zumindest zu reduzieren.

Die Figur 3 zeigt nun die zweite Leiterbahn-Ebene 20. Diese weist den Leiterbahnen 11 der ersten Leiterbahn-Ebene 10 entsprechende Leiterbahnen 21 auf, wobei die einzelnen Leiterbahnen 21a-21f durch entsprechende Schlitze 23a-23f voneinander getrennt sind. Die zur Trennung der Leiterbahnen 11 durch die Schlitze 13 bei der ersten Leiterbahn-Ebene 10 gemachten Ausführungen gelten hier entsprechend, sodass es ausreicht, auf die Darstellung der Figur 3 zu verweisen, aus der klar ersichtlich ist, welche Schlitze 23a-23f welche Leiterbahnen 21a-21f voneinander trennen. Es soll nur darauf hingewiesen werden, dass es bei der zweiten Leiterbahn-Ebene 20 - genauso wie bei der ersten Leiterbahn-Ebene 10 - nicht erforderlich ist, jeden der einzelnen Schlitze 23 isoliert auszubilden. Z. B. bilden bei der zweiten Leiterbahn-Ebene 20 die Schlitze 23a, 23b und 23c Abschnitte eines von in der Figur 3 linken Randes 20a der zweiten Leiterbahn-Ebene 20 zu deren oberen Rand 20d durchgehenden Schlitzes 23' aus. In entsprechender Art und Weise bilden die Schlitze 23d, 23e und 23f Abschnitte eines vom linken Rand 20a zum unteren Rand 20c der zweiten Leiterbahn-Ebene 20 durchgehenden Schlitzes 23" aus.

Man erkennt aus der Figur 3, dass auch die zweite Leiterbahn-Ebene 20 entlang ihrer Randbereiche 20a-20d Bereiche 24 aufweist, welche frei oder zumindest weitgehend frei von einer elektrisch leitenden Schicht sind.

Zur Herstellung der im hier gezeigten Fall aus den beiden Leiterbahn-Ebenen 10 und 20 und der zwischen diesen beiden Leiterbahn-Ebenen 10 und 20 angeordneten Isolator 30, hier der Folie 31 aus einem isolierenden Material, bestehenden Leiterbahnstruktur 1 werden - wie nachstehend beschrieben - die erste Leiterbahn-Ebene 10, der Isolator 30 und die zweite Leiterbahn-Ebene 20 übereinander gelegt, wobei - wie aus Figur 5 ersichtlich - der Isolator 30 zwischen diesen beiden Leiterbahn-Ebenen 10 und 20 angeordnet ist. Man gelangt dann zu dem in der Figur 1 gezeigten Aufbau der Leiterbahnstruktur 1.

Wesentlich ist nun, dass - wie aus der vorgenannten Figur 1 sowie dem Querschnitt der Figur 5 ersichtlich ist - die Schlitze 13 der ersten Leiterbahn-Ebene 10 und die Schlitze 23 der zweiten Leiterbahn-Ebene 20 versetzt zueinander angeordnet sind. Man erkennt aus den Figuren 1 und 5, dass der Schlitz 13a der ersten Leiterbahn-Ebene 10 weiter außen angeordnet ist als der Schlitz 23a der zweiten Leiterbahn-Ebene 20. In entsprechender Art und Weise ist der Schlitz 23b der zweiten Leiterbahn-Ebene 10 weiter innen angeordnet als der Schlitz 13b der ersten Leiterbahn-Ebene 10. Der Schlitz 13e der ersten Leiterbahn-Ebene 10 ist näher am zweiten Rand 10b der ersten Leiterbahn-Ebene 10 angeordnet, als der Schlitz 23e der zweiten Leiterbahn-Ebene 20 von deren zweiten Rand 20b beabstandet ist. Der Schlitz 23f der zweiten Leiterbahn-Ebene 20 ist weiter von deren ersten Rand 20a beabstandet als der Schlitz 13f der ersten Leiterbahn-Ebene 10 von ihrem ersten Rand 10a beabstandet ist.

Durch diese versetzte Anordnung entsprechender Schlitze 13a, 23a bzw. 13b, 23b sowie 13e und 23e und 13f, 23f wird in vorteilhafter Art und Weise eine verbesserte mechanische Stabilität der aus den beiden Leiterbahn-Ebenen 10 und 20 sowie dem zwischen ihnen angeordneten Isolator 30 ausgebildeten Leiterbahnstruktur 1 erreicht, da - im Gegensatz zu bekannten Leiterbahnstrukturen - benachbarte Leiterbahnen der jeweiligen Leiterbahn-Ebene 10 bzw. 20 trennende Schlitze 13 bzw. 23 nun nicht mehr - in einer Draufsicht auf die Ebene der Leiterbahnstruktur 1 gesehen - übereinander liegen, sondern in einer hierzu orthogonalen Richtung versetzt sind. Dies wird besonders deutlich aus der Schnittdarstellung der Figur 5. Hierdurch wird in vorteilhafter Art und Weise die mechanische Stabilität, insbesondere die Verwindungssteifigkeit der aus den Leiterbahn-Ebenen 10 und 20 und dem zwischen diesen liegenden Isolator 30 ausgebildeten Leiterbahnstruktur 1 verbessert.

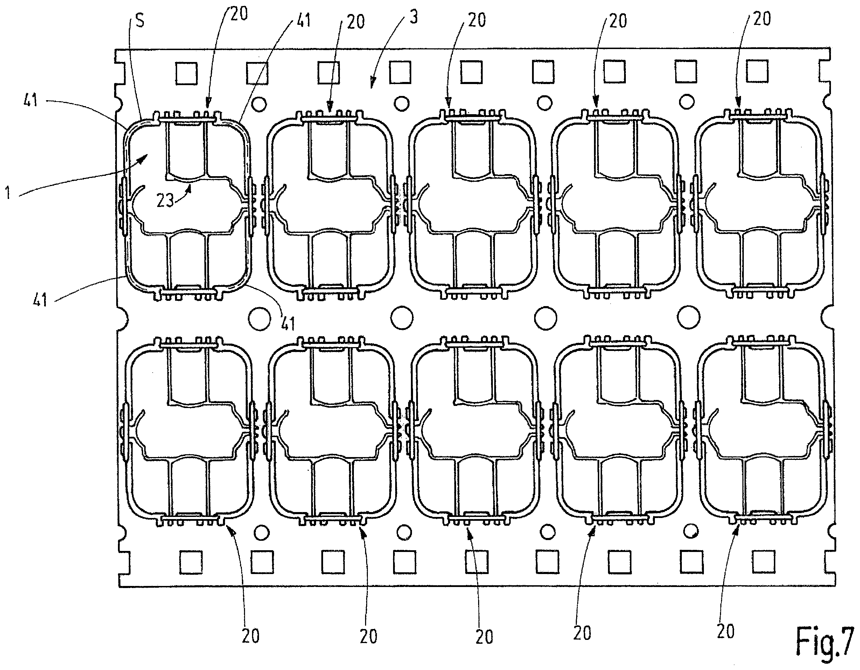

Die Herstellung der vorstehend beschriebenen Leiterbahnstruktur 1 wird anhand der Figuren 6 und 7 beschrieben. Diese erfolgt vorzugsweise im sogenannten "reel-to-reel"-Verfahren. Hierzu werden in bekannter und daher nicht mehr im Detail beschriebenen Art und Weise in ein auf einer Rolle aufgerolltes, eine elektrisch leitfähige Schicht aufweisendes Trägermaterial entsprechende Strukturen eingebracht.

In das Trägermaterial 2 der Figur 6, aus dem erste Leiterbahn-Ebenen 10 hergestellt werden, werden also die Schlitze 13 und die Bondöffnungen 12a-12e eingebracht. In das Trägermaterial 3 der Figur 7, aus dem zweite Leiterbahn-Ebenen 20 hergestellt werden, folglich die Schlitze 23. Die Bearbeitung des Trägermaterials 2 bzw. 3 zur Ausbildung der Leiterbahn-Ebenen 10 bzw. 20 erfolgt hierbei vorzugsweise durch ein Stanzen oder ein sonstiges zur Herstellung derartiger Leiterbahn-Ebenen 10 bzw. 20 geeignetes Verfahren.

Die entsprechenden bearbeitenden Trägermaterialien 2 bzw. 3 werden dann wieder auf einer weiteren Rolle aufgerollt. Auch dies ist bekannt und muss daher nicht mehr näher beschrieben werden.

Zur Ausbildung der Leiterbahnstrukturen 1 werden die erste Leiterbahn-Ebene 10 und die zweite Leiterbahn-Ebene 20 lagerichtig übereinander angeordnet, wobei zwischen diese beiden Leiterbahn-Ebenen 10 und 20 die isolierende Folie 31, also der Isolator 30, angeordnet wurde. Das Trägermaterial 2, der Isolator 30 sowie das Trägermaterial 3 werden dann miteinander verbunden, sodass eine - wie im hier beschriebenen Fall - dreilagige Struktur ausgebildet wird. Bevorzugt wird hierbei, dass der Isolator 30, also in dem hier beschriebenen Fall die Folie 31 aus isolierendem Material - als eine beidseitig klebende Folie ausgebildet ist. Diese besitzt den Vorteil, dass durch einfache Art und Weise die Unterseite 2' des ersten Trägermaterials 2 mit der Oberseite 30' des Isolators 30 und die Oberseite 3' des zweiten Trägermaterials 3 mit der Unterseite 30" des Isolators 30 verbunden werden kann. Hiermit wird die hier beschriebene dreilagige Struktur, gebildet aus dem Trägermaterial 2, dem Isolator 30 und dem Trägermaterial 3, - ausgebildet, aus der dann die einzelnen Leiterbahnstrukturen 1 vereinzelt werden können. Dies erfolgt durch eine entsprechende Trenntechnik, insbesondere durch einen Stanzvorgang, sodass aus der vorstehend beschriebenen Struktur eine Vielzahl von Leiterbahnstrukturen 1, wie in Figur 1 dargestellt, herausgetrennt werden können. In den Figuren 6 und 7 ist durch eine strichlierte Linie S die Außenkontur einer Leiterbahnstruktur 1 (die in den Figuren 6 und 7 links oben dargestellte Leiterbahnstruktur 1) nach dem Trennvorgang angedeutet.

Bei der Durchführung eines derartigen Trennvorgangs zur Vereinzelung der Leiterbahnstrukturen 1 besteht die Gefahr, dass in Folge der mechanischen Beaufschlagung der Randbereiche 10a-10d der ersten Leiterbahn-Ebene 10 mit dem Trennwerkzeug elektrisch leitendes Material dieses Randbereichs zu der Oberfläche der unter dieser liegenden zweiten Leiterbahn-Ebene 20 gedrückt wird, sodass hierdurch eine zu Funktionsbeeinträchtigungen und Funktionsstörungen führende elektrisch leitende Verbindung zwischen den beiden Leiterbahn-Ebenen 10 und 20 hervorgerufen werden könnte. Um dem entgegenzuwirken, oder die Gefahr einer derartigen unerwünschten elektrischen Kontaktierung der beiden Leiterbahn-Ebenen 10 und 20 zumindest zu reduzieren, ist - wie vorstehend bereits angesprochen - bei dem beschriebenen Ausführungsbeispiel vorgesehen, dass - wie am besten aus der Figur 1 und dem Querschnitt der Figur 5 ersichtlich ist - die Randbereiche 10a-10d der ersten Leiterbahn-Ebene 10 weitgehend frei von elektrisch leitendem Material sind, da dort die Bereiche vorgesehen sind. Aus der Draufsicht der Figur 1 erkennt man den über die Ränder 10a-10d hervorstehenden Randbereich 33 der zwischen der ersten Leiterbahn-Ebene 10 und der zweiten Leiterbahn-Ebene 20 angeordneten isolierenden Folie 31.

Wie ebenfalls bereits vorstehend angesprochen, weist auch die zweite Leiterbahn-Ebene 20 in ihren Randbereichen 20a-20d die von dem elektrisch leitenden Material freien Bereiche 24 auf.

Durch diese Ausgestaltung der ersten Leiterbahn-Ebene 10 und/oder der zweiten Leiterbahn-Ebene 20 mit den Bereichen 14 bzw. 24 wird vorzugsweise dadurch erreicht, dass aus dem Trägermaterial 2, aus dem - wie vorstehend beschrieben - eine Vielzahl von ersten Leiterbahn-Ebenen 10 ausgebildet werden, weitere Bereiche 40 der elektrisch leitenden Schicht dieses Trägermaterials 2 herausgetrennt werden.

Die Bereiche 14, 24 werden derart ausgebildet, dass aus dem Trägermaterial 2 bzw. 3 die Bereiche 40 bzw. 41 herausgestanzt oder auf sonstige Art und Weise frei von elektrisch leitendem Material gemacht werden.

Zusammenfassend ist festzuhalten, dass durch die beschriebenen Maßnahmen eine Leiterbahnstruktur 1 ausgebildet wird, welche sich dadurch auszeichnet, dass durch die ebenweise versetzte Anordnung von benachbarten Leiterbahnen 11 bzw. 21 der Leiterbahn-Ebenen 10 bzw. 20 trennenden Schlitzen 13 bzw. 23 eine verbesserte mechanische Stabilität, insbesondere eine erhöhte Verwindungssteifigkeit, der wie beschrieben ausgebildeten Leiterbahnstruktur 1 erreicht wird. Indem optional vorgesehen ist, dass - was eine konstruktive Maßnahme von eigenständig patentbegründender Bedeutung darstellt - zumindest diejenigen Randbereiche 10a-10d der ersten Leiterbahn-Ebene 10, also derjenigen der beiden Leiterbahn-Ebenen 10, 20, von der ausgehend der Trennvorgang mittels eines Trennwerkzeugs erfolgt, zumindest im Wesentlichen frei von isolierendem Material gehalten wird, wird einer unerwünschten Kontaktierung zwischen einer oder mehreren Leiterbahnen 11 der ersten Leiterbahn-Ebene 10 und mindestens einer Leiterbahn 21 der zweiten Leiterbahn-Ebene 20 in vorteilhafter Art und Weise zumindest entgegengewirkt.

## Patentansprüche

1. Leiterbahnstruktur, insbesondere für einen Lead-Frame für eine Smartcard-Anwendung, die mindestens eine erste Leiterbahn-Ebene (10) mit mehreren ersten Leiterbahnen (11; 11a-11f) und mindestens eine zweite Leiterbahn-Ebene (20) mit mehreren zweiten Leiterbahnen (21; 21a-21f) besitzt, wobei übereinander liegende Leiterbahn-Ebenen (10, 20) von einem Isolator (30) getrennt sind, wobei mindestens eine erste Leiterbahn (11; 11a, 11b, 11c, 11d, 11f) der ersten Leiterbahn-Ebene (10) mindestens eine sie durchsetzende Bondöffnung (12; 12a-12e) und der Isolator (30) eine unter dieser mindestens einen Bondöffnung (12; 12a-12e) liegende Durchtrittsöffnung (32a-32e) aufweist, durch welche ein Bonddraht hindurchführbar und in elektrisch leitenden Kontakt mit einer ersten Leiterbahn (21; 21a-21f) der zweiten Leiterbahn-Ebene (20) bringbar ist, und wobei mindestens die vorgenannte erste Leiterbahn der ersten Leiterbahn-Ebene (10) und die zu ihr benachbarte Leiterbahn (11; 11a, 11b; 11b, 11c; 11d, 11e; 11e, 11f) der ersten Leiterbahn-Ebene (10) durch einen Schlitz (13; 13a-13i) und mindestens die vorgenannte erste Leiterbahn der zweiten Leiterbahn-Ebene (20) und die zu ihr benachbart liegende Leiterbahn (21a, 21b; 21b, 21c, 21d, 21e; 21e, 21f) der zweiten Leiterbahn-Ebene (20) durch einen weiteren Schlitz (23, 23a-23e) voneinander getrennt sind, **dadurch gekennzeichnet, dass** dieser mindestens eine Schlitz (13; 13a-13i) der ersten Leiterbahn-Ebene (10) in Bezug auf den vorgenannten mindestens einen weiteren Schlitz (23; 23a-23e) der zweiten Leiterbahn-Ebene (20) versetzt angeordnet ist.

2. Leiterbahnstruktur nach Anspruch 1, **dadurch gekennzeichnet, dass** mindestens ein Schlitz (13; 13a-13h) durch eine Bondöffnung (12a-12e) hindurchläuft, in diese mündet oder von dieser ausgeht.

3. Leiterbahnstruktur nach einem der vorangehenden Ansprüche, **dadurch gekennzeichnet, dass** der zwischen den benachbarten Leiterbahn-Ebenen (10, 20) angeordnete Isolator (30) als eine elektrisch isolierende Folie (31) mit mindestens einer Durchtrittsöffnung (32a-32e) für einen Bonddraht ausgebildet ist.

4. Leiterbahnstruktur nach Anspruch 3, **dadurch gekennzeichnet, dass** die Folie (31) an mindestens einer Seite und vorzugsweise an beiden Seiten mit einer Klebstoffschicht versehen ist.

5. Leiterbahnstruktur nach einem der vorangehenden Ansprüche, **dadurch gekennzeichnet, dass** mindestens eine Leiterbahn-Ebene (10; 20) der Leiterbahnstruktur (1) zumindest in einem Teilbereich (14; 24) ihres Randbereichs (10a-10d; 20a-20d) zumindest weitgehend frei von dem elektrisch leitenden Material ist.

6. Elektronische Vorrichtung, insbesondere Smartcard, die eine Leiterbahnstruktur (1) zur Aufnahme eines elektronischen Bauteils, insbesondere eines Chips, aufweist, der in oder auf die Leiterbahnstruktur (1) ein- bzw. aufsetzbar und mit mindestens einem Bonddraht mit der Leiterbahnstruktur (1) verbindbar ist, **dadurch gekennzeichnet, dass** die Leiterbahnstruktur (1) nach einem der Ansprüche 1 bis 5 ausgebildet ist.

7. Verfahren zur Herstellung einer Leiterbahnstruktur nach einem der Ansprüche 1 bis 5, **dadurch gekennzeichnet, dass** in ein Trägermaterial (2; 3) Schlitze (13; 23) zur Trennung benachbart liegender Leiterbahnen (11; 21) eingebracht werden.

8. Verfahren nach Anspruch 7, **dadurch gekennzeichnet, dass** aus der elektrisch leitenden Schicht des Trägermaterial (2) zur Ausbildung eines nicht leitenden Randbereichs (10a-10d) der Leiterbahn-Ebene (10) Aussparungen (40) eingebracht werden.

## Claims

1. Conductor path structure, in particular for a lead frame for a smart card application, comprising at least one first conductor path plane (10) having several first conductor paths (11; 11a-11f) and at least a second conductor path plane (20) having several second conductor paths (21; 21a-21f), wherein superimposed conductor path planes (10, 20) are separated by an insulator (30), wherein at least one first conductor path (11; 11a, 11b, 11c, 11d, 11f) of the first conductor path plane (10) has got at least one bond opening (12; 12a-12e) traversing it and the insulator (30) comprises a through opening being arranged below the at least one bond opening (12; 12a-12e), through which a bond wire can be led and can be brought in electric contact with a first conductor path (21; 21a-21f) of the second conductor path plane (20), and wherein said first conductor path of the first conductor path plane (10) and the adjacent conductor path (11; 11a, 11b; 11b, 11c; 11d, 11e; 11e, 11f) of the first conductor path plane (10) are separated by a slot (13; 13a-13i) and said first conductor path of the second conductor path plane (20) and the adjacent conductor path (21a, 21b; 21b, 21c, 21d, 21e; 21e, 21f) are separated by a further slot (23, 23a-23e), **characterized in that** said at least one slot (13; 13a-13i) of the first conductor path plane (10) is arranged offset in relation to said at least one further slot (23; 23a-23e) of the second conductor path plane (20).

2. Conductor path structure according to claim 1, **characterized in that** at least one slot (13; 13a-13h) passes through a bond opening (12a-12e), ends in it or starts from it.

3. Conductor path structure according to one of the previous claims, **characterized in that** the insulator (30) arranged between adjacent conductor path planes (10, 20) is provided as an electrically insulating foil (31) having at least one through opening for a bond wire.

4. Conductor path structure according to claim 3, **characterized in that** the foil (31) is provided with an adhesive layer at least on one side and preferably on both sides.

5. Conductor path structure according to one of the previous claims, **characterized in that** at least one conductor path plane (10; 20) of the conductor path structure (1) is provided at least in a partial area (14; 24) of its edge area (10a-10d; 20a-20d) at least substantially free of the electrically conductive material.

6. Electronic device, in particular smart card, having a conductor path structure (1) for receiving an electronic component, in particular a chip, which can be inserted or set upon the conductor path structure (1) and can be connected with at least one bond wire with the conductor path structure (1), **characterized in that** the conductor path structure (1) is provided according to one of the claims 1 to 5.

7. Method for manufacturing a conductor path structure according to one of the claims 1 to 5, **characterized in that** in a carrier material (2; 3) slots (13; 23) for separating adjacent conductor paths (11, 21) are provided.

8. Method according to claim 7, **characterized in that** for forming nonconductive edge areas (10a-10d) of the conductor path plane (10) recesses (40) are provided.

## Revendications

1. Structure de pistes conductrices, en particulier pour une grille de connexion pour une utilisation avec une carte à puce intelligente, qui possède au moins un premier plan de pistes conductrices (10) avec plusieurs premières pistes conductrices (11 ; 11a - 11f) et au moins un deuxième plan de pistes conductrices (20) avec plusieurs deuxièmes pistes conductrices (21 ; 21a - 21f), dans laquelle des plans de pistes conductrices (10, 20) superposés sont séparés par un isolateur (30), dans laquelle au moins une première piste conductrice (11 ; 11a, 11b, 11c, 11d, 11f) du premier plan de pistes conductrices (10) présente au moins une ouverture de connexion (12 ; 12a - 12e) le traversant et l'isolateur (30), une ouverture de passage située sous ladite au moins une ouverture de connexion (12 ; 12a - 12e), à travers laquelle un fil de connexion peut être guidé et peut être mis en contact électroconducteur avec une première piste conductrice (21 ; 21a - 21f) du deuxième plan de pistes conductrices (20), et dans laquelle au moins la première piste conductrice susmentionnée du premier plan de pistes conductrices (10) et la piste conductrice (11 ; 11a, 11b ; 11b, 11c ; 11d, 11e ; 11e, 11f), qui lui est adjacente, du premier plan de pistes conductrices (10) sont séparées l'une de l'autre par une entaille (13 ; 13a - 13i) et au moins la première piste conductrice susmentionnée du deuxième plan de pistes conductrices (20) et la piste conductrice (21a, 21b ; 21b, 21c, 21d, 21e ; 21e, 21f), qui lui est adjacente, du deuxième plan de pistes conductrices (20), par une autre entaille (23, 23a, 23e), **caractérisée en ce que** ladite au moins une entaille (13 ; 13a - 13i) du premier plan de pistes conductrices (10) est disposée de manière décalée par rapport à l'au moins une autre entaille (23 ; 23a - 23e) susmentionnée du deuxième plan de pistes conductrices (20).

2. Structure de pistes conductrices selon la revendication 1, **caractérisée en ce qu'**au moins une entaille (13 ; 13a - 13h) traverse une ouverture de connexion (12a - 12e) de part en part, débouche dans celle-ci ou part de celle-ci.

3. Structure de pistes conductrices selon l'une quelconque des revendications précédentes, **caractérisée en ce que** l'isolateur (30) disposé entre les plans de pistes conductrices (10, 20) adjacents est réalisé en tant que film (31) isolant électriquement avec au moins une ouverture de passage pour un fil de connexion.

4. Structure de pistes conductrices selon la revendication 3, **caractérisée en ce que** le film (31) est pourvu, au niveau au moins d'un côté et de préférence au niveau des deux côtés, d'une couche de colle.

5. Structure de pistes conductrices selon l'une quelconque des revendications précédentes, **caractérisée en ce qu'**au moins un plan de pistes conductrices (10 ; 20) de la structure de pistes conductrices (1) est, au moins dans une zone partielle (14 ; 24) de sa zone de bord (10a - 10d ; 20a - 20d), au moins largement dépourvu du matériau électroconducteur.

6. Dispositif électronique, en particulier carte à puce intelligente, qui présente une structure de pistes conductrices (1) servant à recevoir un composant électronique, en particulier une puce, qui peut être inséré dans ou placé sur la structure de pistes conductrices (1) et peut être relié avec au moins un fil de connexion à la structure de pistes conductrices (1), **caractérisé en ce que** la structure de pistes conductrices (1) est réalisée selon l'une quelconque des revendications 1 à 5.

7. Procédé servant à fabriquer une structure de pistes conductrices selon l'une quelconque des revendications 1 à 5, **caractérisé en ce que** des entailles (13 ; 23) servant à séparer des pistes conductrices (11 ; 21) situées de manière adjacente sont pratiquées dans un matériau de support (2 ; 3).

8. Procédé selon la revendication 7, **caractérisé en ce que**, depuis la couche électroconductrice du matériau de support (2), des évidements (40) sont pratiqués pour réaliser une zone de bord (10a - 10d) non conductrice du plan de pistes conductrices (10).
